# EUROPEAN PATENT SPECIFICATION

(11) **EP 2 359 402 B1**
(45) Date of publication and mention of the grant of the patent: **24.10.2012**
(21) Application number: 09764111.2
(22) Date of filing: 25.11.2009
(51) Int. Cl.: H01L 27/146, H01L 27/148

(54) **METHOD OF FABRICATING IMAGE SENSORS WITH LATERAL OVERFLOW DRAINS**
VERFAHREN ZUR HERSTELLUNG VON BILDSENSOREN MIT LATERALÜBERLAUFSENKEN
PROCÉDÉ DE FABRICATION DE CAPTEURS D'IMAGE À DRAINS DE TROP-PLEINS LATÉRAUX

(30) Priority: 10.12.2008 US 121227 P; 30.10.2009 US 609296
(43) Date of publication of application: 24.08.2011
(73) Proprietor: Truesense Imaging, Inc., Newcastle DE 19801 (US)
(72) Inventor: BANGHART, Edmund, Kenneth, Rochester NY 14650-2201 (US); STEVENS, Eric, Gordon, Rochester NY 14650-2201 (US); DOAN, Hung, Quoc, Rochester NY 14650-2201 (US)
(74) Representative: Somervell, Thomas Richard
(86) International application number: PCT/US2009/006283
(87) International publication number: WO 2010/068244

(56) References cited:
- EP-A2- 1 289 019
- US-A- 5 585 298
- US-A1- 2002 140 003
- US-B1- 6 794 219

## Description

### TECHNICAL FIELD

The present invention relates generally to image sensors for use in digital cameras and other types of image capture devices, and more particularly to image sensors having lateral overflow drain and channel stop regions.

### BACKGROUND

A typical electronic image sensor includes a number of photosensitive picture elements ("pixels") arranged in a two-dimensional array. The pixels accumulate charge carriers in response to light striking the pixels, and each pixel has a maximum amount of charge it can store. A phenomenon known as "blooming" occurs when the total number of charge carriers collected by a pixel exceeds the charge capacity for that pixel and the excess charge spills over into adjacent pixels. One known anti-blooming technique forms a lateral overflow drain (LOD) within a pixel to provide a means for draining the excess charge carriers from the pixel before the charge carriers spill into adjacent pixels.

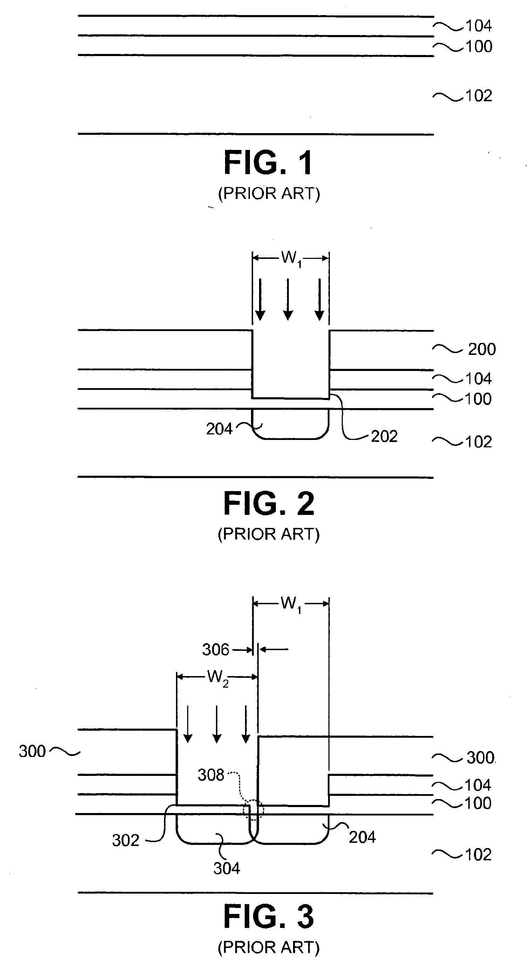

**FIGS. 1-3** depict a method of forming lateral overflow drain and channel stop regions in accordance with the prior art. Initially, as shown in **FIG. 1**, an insulating layer 100 is formed over a substrate or well 102. A nitride layer 104 is then formed over the insulating layer 100. Documents US 5585298 and EP 1289019 show other prior-art methods of forming lateral overflow drains and channel stop regions in an imaging device.

**FIG. 2** illustrates mask layer 200 formed on nitride layer 104 and patterned to form an opening having a width W₁. The portion of nitride layer 104 that is exposed in the opening is etched away. Nitride layer 104 is commonly over etched to accommodate for variations in the thickness of nitride layer 104. This overetching removes a portion 202 of insulating layer 100. A dopant is then implanted into substrate 102 (represented by arrows) to form channel stop 204. Channel stop 204 prevents charge carriers from spilling to horizontally adjacent pixels.

Mask layer 200 is then removed and another mask layer 300 is formed on the remaining nitride layer 104 and the exposed portion of insulating layer 100 (**FIG. 3**). Mask layer 300 is patterned to form an opening having a width W₂, and the portion of nitride layer 104 exposed in the second opening is etched away. Again, nitride layer 104 is typically over etched to account for variations in the thickness of nitride layer 104, thereby removing another portion 302 of insulating layer 100. A dopant is then implanted into substrate 102 (represented by arrows) to form lateral overflow drain 304.

To ensure that all of nitride layer 104 that overlies the lateral overflow drain region is removed prior to the formation of the lateral overflow drain 302, W₂ typically overlaps with W₁, creating overlap area 306. When nitride layer 104 is etched as shown in **FIGS. 2** and **3**, the portion 308 of insulating layer 100 located in overlap area 306 is etched twice. This double-etching can remove portion 308 completely, thereby exposing the top surface of substrate 102 and allowing the substrate surface to be damaged during subsequent processing steps. Exposing or damaging the top surface of substrate 102 can potentially result in contamination of substrate 102 and produce defects in the image sensor, such as, for example, cluster defects.

### SUMMARY

A lateral overflow drain and a channel stop are fabricated using a double mask layer process as defined in claim 1. A hard mask layer is formed over an insulating layer. The insulating layer is disposed on a substrate, layer, or well having a first conductivity type. The hard mask layer is patterned to create one or more first openings. A second mask layer is then formed on the hard mask layer and patterned to create one or more second openings. Each second opening is disposed in a portion of a respective first opening, and a portion of the second mask layer is disposed in the remaining portion of the first opening.

One or more dopants having a second conductivity type opposite the first conductivity type are then implanted through each second opening and into the substrate, layer, or well to form one or more lateral overflow drains. The second mask layer is then removed, and one or more dopants having the same conductivity type as the substrate, layer, or well are implanted through the first openings and into the lateral overflow drains and adjoining substrate, layer, or well to form channel stops. Due to the use of two mask layers, one edge of each lateral overflow drain is aligned, or substantially aligned, with an edge of a respective channel stop. The hard mask layer is then removed and the device processed further using known fabrication steps.

### ADVANTAGEOUS EFFECT OF THE INVENTION

The present invention includes the advantage of forming one or more lateral overflow drains without damaging any underlying layers. Additionally, the present invention provides accurate and repeatable methods for fabricating lateral overflow drains and channel stops with minimal feature sizes. This is particularly beneficial in high resolution image sensors.

### BRIEF DESCRIPTION OF THE DRAWINGS

Embodiments of the invention are better understood with reference to the following drawings. The elements of the drawings are not necessarily to scale relative to each other.
**FIGS. 1-3** depict a method of forming lateral overflow drain and channel stop regions in accordance with the prior art;
**FIG. 4** is a simplified block diagram of an image capture device in an embodiment in accordance with the invention;
**FIG. 5** is a simplified block diagram of image sensor 406 shown in **FIG. 4** in an embodiment in accordance with the invention;
**FIG. 6** is a simplified diagram of pixel 500 shown in **FIG. 5** in an embodiment in accordance with the invention;
**FIGS. 7-12** are cross section views of a portion of pixel 500 along line A-A' in **FIG. 6** illustrating a method of forming lateral overflow drain 610 and channel stop 608 in an embodiment in accordance with the invention; and
**FIGS. 13-15** are cross section views of a portion of pixel 500 along line A-A' in **FIG. 6** illustrating alternate techniques that can be performed instead of the techniques shown in **FIGS. 8-10** in an embodiment in accordance with the invention.

### DETAILED DESCRIPTION

Throughout the specification and claims, the following terms take the meanings explicitly associated herein, unless the context clearly dictates otherwise. Directional terms such as "on", "over", "top", "bottom", are used with reference to the orientation of the Figure(s) being described. Because components of embodiments of the present invention can be positioned in a number of different orientations, the directional terminology is used for purposes of illustration only and is in no way limiting. When used in conjunction with layers of an image sensor wafer or corresponding image sensor, the directional terminology is intended to be construed broadly, and therefore should not be interpreted to preclude the presence of one or more intervening layers or other intervening image sensor features or elements. Thus, a given layer that is described herein as being formed on or formed over another layer may be separated from the latter layer by one or more additional layers.

Additionally, the terms "wafer" and "substrate" are to be understood as a semiconductor-based material including, but not limited to, silicon, silicon-on-insulator (SOI) technology, doped and undoped semiconductors, epitaxial layers formed on a semiconductor substrate, and other semiconductor structures.

Referring to the drawings, like numbers indicate like parts throughout the views.

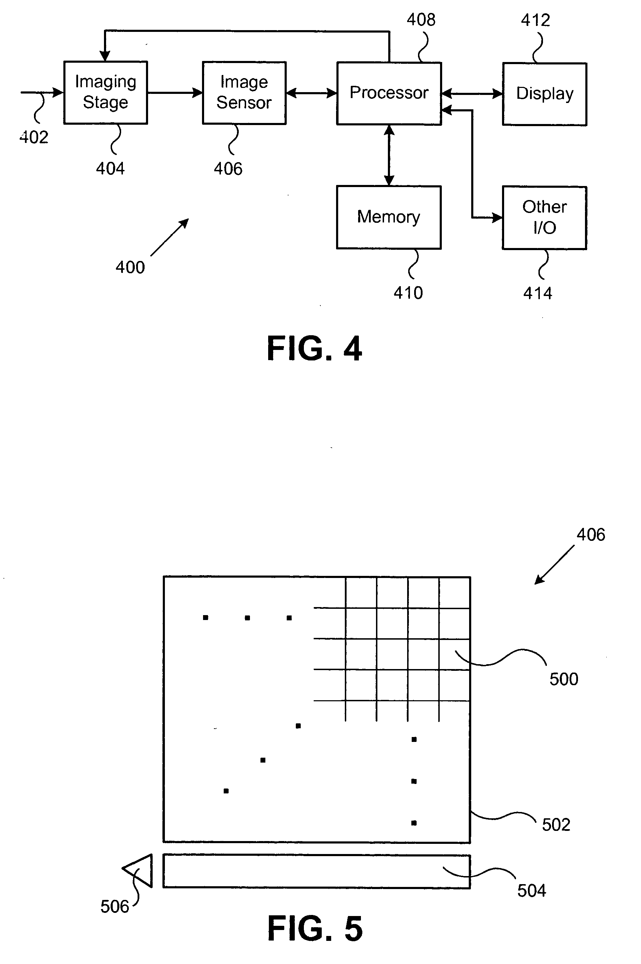

**FIG. 4** is a simplified block diagram of an image capture device in an embodiment in accordance with the invention. Image capture device 400 is implemented as a digital camera in **FIG. 4**. Those skilled in the art will recognize that a digital camera is only one example of an image capture device that can utilize an image sensor incorporating the present invention. Other types of image capture devices, such as, for example, cell phone cameras, scanners, and digital video camcorders can be used with the present invention.

In digital camera 400, light 402 from a subject scene is input to an imaging stage 404. Imaging stage 404 can include conventional elements such as a lens, a neutral density filter, an iris and a shutter. Light 402 is focused by imaging stage 404 to form an image on image sensor 406. Image sensor 406 captures one or more images by converting the incident light into electrical signals. Digital camera 400 further includes processor 408, memory 410, display 412, and one or more additional input/output (I/O) elements 414. Although shown as separate elements in the embodiment of **FIG. 4**, imaging stage 404 may be integrated with image sensor 406, and possibly one or more additional elements of digital camera 400, to form a camera module. For example, a processor or a memory may be integrated with image sensor 406 in a camera module in embodiments in accordance with the invention.

Processor 408 may be implemented, for example, as a microprocessor, a central processing unit (CPU), an application-specific integrated circuit (ASIC), a digital signal processor (DSP), or other processing device, or combinations of multiple such devices. Various elements of imaging stage 404 and image sensor 406 may be controlled by timing signals or other signals supplied from processor 408.

Memory 410 may be configured as any type of memory, such as, for example, random access memory (RAM), read-only memory (ROM), Flash memory, disk-based memory, removable memory, or other types of storage elements, in any combination. A given image captured by image sensor 406 may be stored by processor 408 in memory 410 and presented on display 412. Display 412 is typically an active matrix color liquid crystal display (LCD), although other types of displays may be used. The additional I/O elements 414 may include, for example, various on-screen controls, buttons or other user interfaces, network interfaces, or memory card interfaces.

It is to be appreciated that the digital camera shown in **FIG. 4** may comprise additional or alternative elements of a type known to those skilled in the art. Elements not specifically shown or described herein may be selected from those known in the art. As noted previously, the present invention may be implemented in a wide variety of image capture devices. Also, certain aspects of the embodiments described herein may be implemented at least in part in the form of software executed by one or more processing elements of an image capture device. Such software can be implemented in a straightforward manner given the teachings provided herein, as will be appreciated by those skilled in the art.

Referring now to **FIG. 5**, there is shown a simplified block diagram of image sensor 406 shown in **FIG. 4** in an embodiment in accordance with the invention. Image sensor 406 is implemented as a true two-phase full frame Charge Coupled Device (CCD) image sensor (described later) in **FIG. 4**. Other embodiments in accordance with the invention are not limited to this type of image sensor. By way of example only, image sensor 406 may be implemented as an interline CCD image sensor, or a three or four phase CCD image sensor in other embodiments in accordance with the invention.

Image sensor 406 includes a number of pixels 500 typically arranged in rows and columns to form an imaging area 502. Each pixel 500 is configured as a shift element with each column of pixels forming a vertical shift register. After an image is captured by pixels 500, the accumulated charges are read out of imaging area 502. During image readout, the vertical shift registers shift each row of accumulated charges or signals out to horizontal shift register 504. Horizontal shift register 504 then sequentially shifts the charges to output amplifier 506.

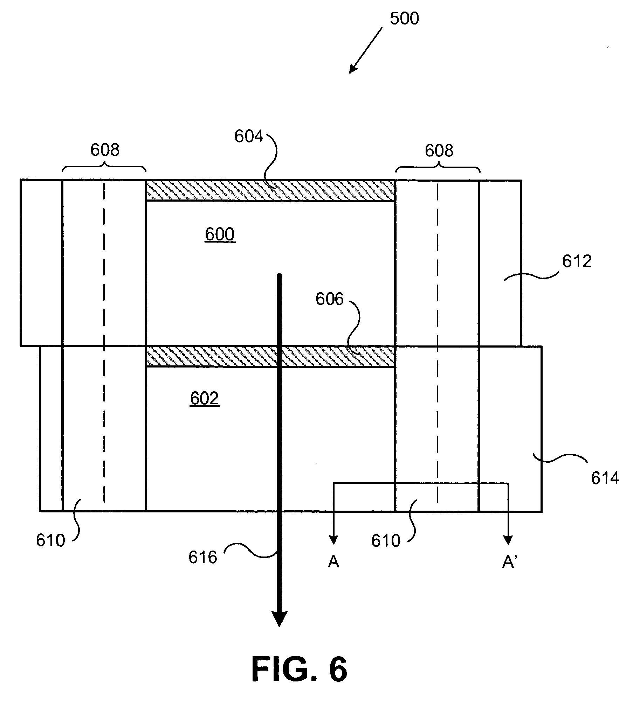

**FIG. 6** is a simplified diagram of pixel 500 shown in **FIG. 5** in an embodiment in accordance with the invention. As discussed earlier, image sensor 406 in **FIG. 5** is implemented as a true two-phase CCD image sensor. When a CCD image sensor includes multiple phases, the vertical CCDs are each separated into multiple parts or "phases" to facilitate the transfer of charge through the structures. Thus, in a true two-phase CCD, each shift element in a vertical CCD has a first phase shift element 600 and a second phase shift element 602.

Barrier regions 604, 606 separate each shift element 600, 602 in pixel 500 from vertically adjacent pixels and facilitate the transfer of charge through the vertical CCD. Channel stop 608 is formed within pixel 500 to prevent charge from spilling to horizontally adjacent pixels. Lateral overflow drain 610 (shown in dashed lines) is formed within channel stop 608, and is used to drain excess or undesirable charge from pixel 500. Lateral overflow drain 610 has a higher dopant concentration than the dopant concentration of channel stop 608 in an embodiment in accordance with the invention.

Overflow barrier regions are also formed in pixel 500. The overflow barrier regions are not shown in FIG. 6 for the sake of clarity. Overflow barrier regions can be designed and fabricated using any known fabrication method. Overflow barrier regions are described, for example, in United States Patents 5,130,774 and 5,349,215.

And finally, gate electrodes 612, 614 are formed over pixel 500 and are made of a transparent material that allows light to pass through electrodes 612, 614. Examples of a transparent material include, but are not limited to, polysilicon and indium-tin-oxide (ITO). Gate electrodes 612, 614 activate the transfer of charge through shift elements 600, 602. A voltage is alternately applied to each gate electrode 612, 614 to shift charge from one shift element to the next shift element. Arrow 616 indicates the direction of the charge transfer through each vertical shift register.

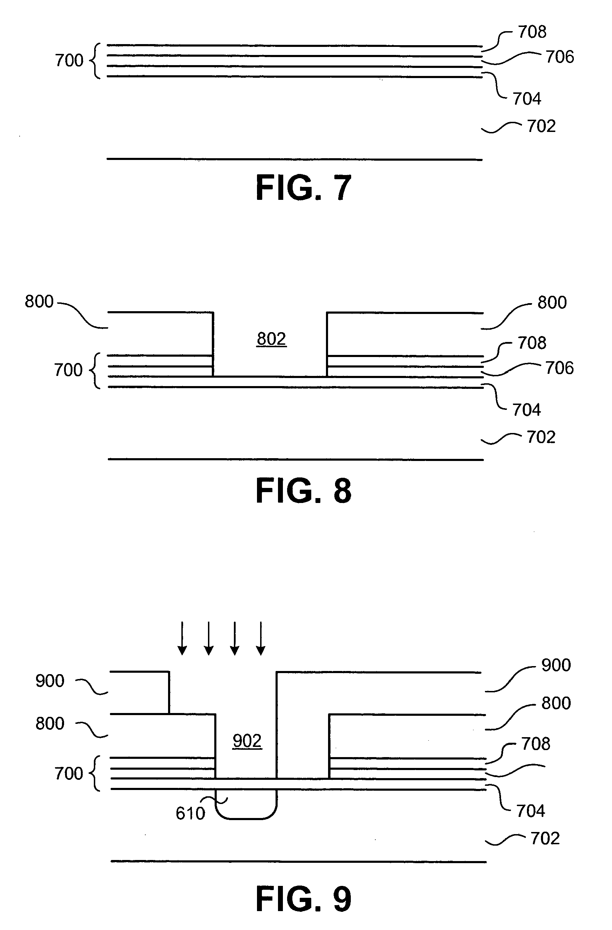

Referring now to **FIGS. 7-12**, there are shown cross section views of a portion of pixel 500 along line A-A' in **FIG. 6** that illustrate a method of forming lateral overflow drain 610 and channel stop 608 in an embodiment in accordance with the invention. **FIG. 7** depicts a portion of a pixel after a number of initial fabrication steps have been completed. The pixel at this stage includes an insulating layer 700 formed over layer 702. By way of example only, insulating layer 700 is implemented as an oxide-nitride-oxide (ONO) layer (layers 704, 706, and 708, respectively) in an embodiment in accordance with the invention. Layer 702 is configured as a substrate, layer, or well having either an n or p conductivity type.

Hard mask layer 800 is then formed over insulating layer 700 and patterned to form opening 802 (**FIG. 8**). By way of example only, hard mask layer 800 can be formed as a silicon nitride or silicon dioxide layer. The portions of oxide layer 708 and nitride layer 706 that are exposed in opening 802 are removed. Oxide layer 704 is not removed and acts as a protection and screening layer in an embodiment in accordance with the invention.

A second mask layer 900 is then formed on hard mask layer 800 and patterned to form opening 902 (**FIG. 9**). Second mask layer 900 is formed by depositing a photoresist on hard mask layer 800 in an embodiment in accordance with the invention. Opening 902 resides in a portion of opening 802 with second mask layer 900 filling in the remaining portion of opening 802.

One or more dopants are then implanted into layer 702 (represented by arrows) to form lateral overflow drain 610. The dopant or dopants used to form lateral overflow drain 610 are of the opposite conductivity type from the conductivity type of layer 702. For example, if layer 702 includes p-type dopants, then lateral overflow drain 610 is formed with n-type dopants. Arsenic is an exemplary n-type dopant that can be implanted with a concentration of 1x10¹⁴ atoms per square centimeter to form lateral overflow drain 610.

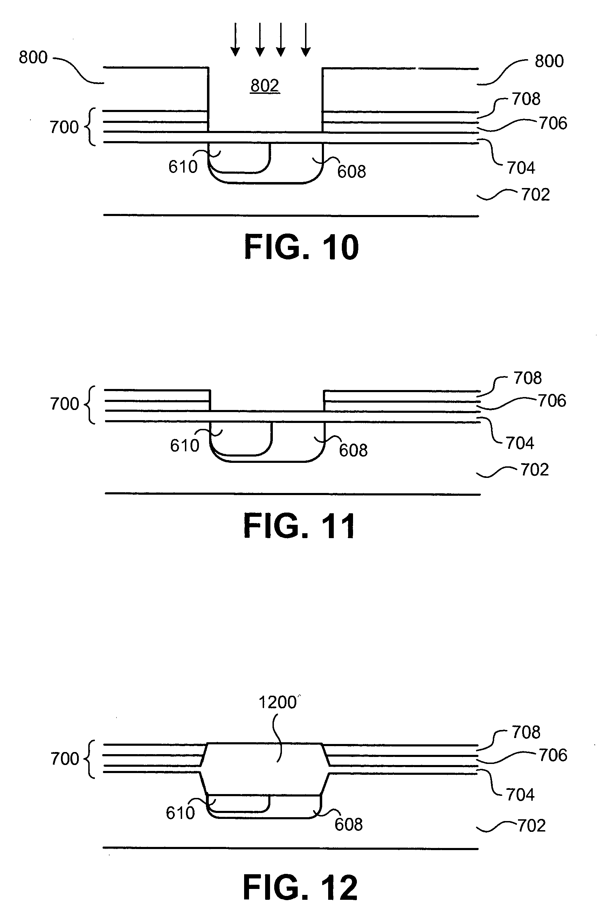

Next, as shown in **FIG.10**, mask layer 900 is removed and one or more dopants are implanted (represented by arrows) through opening 802 and into lateral overflow drain 610 and an adjoining portion of layer 702 to form channel stop 608. The one or more dopants used to form channel stop 608 have the same conductivity type as layer 702. For example, if layer 702 has p-type conductivity, the dopant or dopants used to form channel stop 608 are p-type dopants in an embodiment in accordance with the invention. By way of example only, boron is a p-type dopant that can be implanted with a concentration of 1x10¹³ atoms per square centimeter to form channel stop 608.

Due to the use of two mask layers 800 and 900, one edge of lateral overflow drain 610 is aligned, or substantially aligned, with an edge of channel stop 608. Hard mask layer 800 is then removed, resulting in the structure shown in **FIG. 11**. A field oxide region 1200 is formed over channel stop 608 and lateral overflow drain 610 (**FIG. 12**). Field oxide region 1200 can be formed using any known method. Pixel 500 can now be processed further. Subsequent processing steps may include the formation of a buried channel, an overflow barrier region disposed adjacent to lateral overflow drain 610, and an overlying gate electrode.

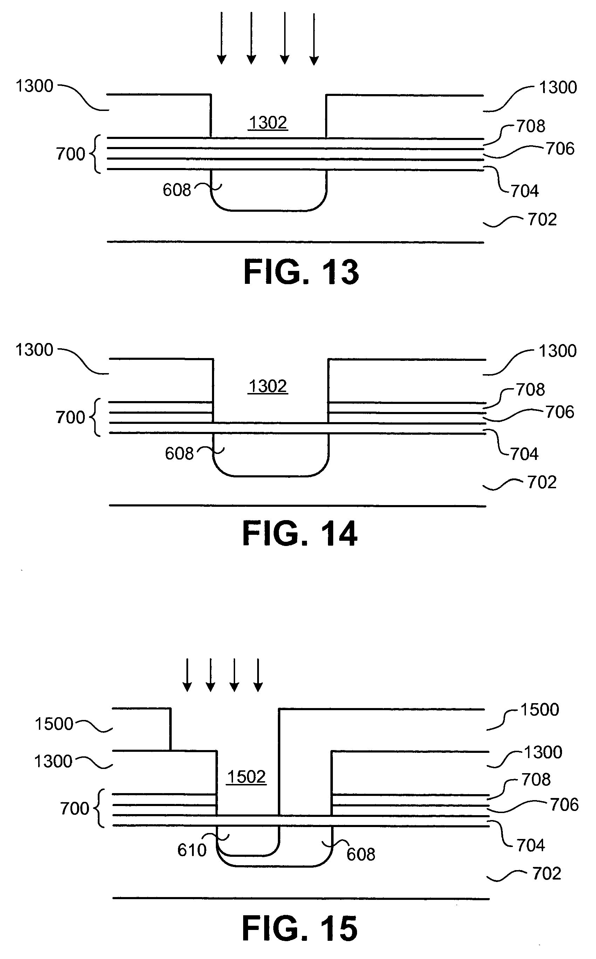

**FIGS. 13-15** are cross section views of a portion of pixel 500 along line A-A' in **FIG. 6** illustrating alternate techniques that can be performed instead of the techniques shown in **FIGS. 8-10** in an embodiment in accordance with the invention. The processing step shown in **FIG. 13** is performed after **FIG. 7**. Mask layer 1300 is formed on insulating layer 700 and patterned to create first opening 1302 (**FIG. 13**). Mask layer 1300 is formed by depositing a photoresist on insulating layer 700 in an embodiment in accordance with the invention. In another embodiment in accordance with the invention, mask layer 1300 is formed by depositing a hard mask layer over insulating layer 700.

One or more dopants are then implanted (represented by arrows) through opening 1302 and into layer 702 to form channel stop 608. The one or more dopants used to form channel stop 608 have the same conductivity type as layer 702. For example, if layer 702 has p-type conductivity, the dopant or dopants used to form channel stop 608 are p-type dopants in an embodiment in accordance with the invention. Boron is an exemplary p-type dopant that can be implanted with a concentration of 1x10¹³ atoms per square centimeter to form channel stop 608. In another embodiment in accordance with the invention, one or more n-type dopants can be used to form channel stop 608 when layer 702 has an n-type conductivity.

Next, as shown in **FIG.14**, oxide layer 708 and nitride layer 706 that are exposed in opening 1302 are removed. Oxide layer 708 and nitride layer 706 are etched with a plasma etch in an embodiment in accordance with the invention. Oxide layer 704 is not removed and acts as a protection and screening layer in an embodiment in accordance with the invention.

Mask layer 1500 is then formed over mask layer 1300 and patterned to create second opening 1502 (**FIG. 15**). Mask layer 1500 is formed by depositing a photoresist over mask layer 1300 in an embodiment in accordance with the invention. Second opening 1502 is disposed in a portion of first opening 1302, and a portion of mask layer 1500 is disposed in the remaining portion of opening 1302.

One or more dopants are then implanted (represented by arrows) through opening 1502 and into channel stop 608 to form lateral overflow drain 610. Due to the dual-mask layers 1300 and 1500, one edge of lateral overflow drain 610 is aligned, or substantially aligned, with an edge of channel stop 608. The dopant or dopants used to form lateral overflow drain 610 are of the opposite conductivity type from channel stop 608. For example, if channel stop 608 includes p-type dopants, then lateral overflow drain 610 is formed with n-type dopants. By way of example only, arsenic is an n-type dopant that can be implanted with a concentration of 1x10¹⁴ atoms per square centimeter to form lateral overflow drain 610.

Mask layer 1500 and mask layer 1300 in **FIG. 15** are removed after lateral overflow drain 610 is formed, resulting in the pixel structure depicted in **FIG. 11**. Field oxide region 1200 is now formed over channel stop 608 and lateral overflow drain 610, as shown in **FIG. 12**. Field oxide region 1200 can be formed using any known method. Pixel 500 can now be processed further. Subsequent processing steps may include the formation of a buried channel, an overflow barrier region disposed adjacent to lateral overflow drain 610, and an overlying gate electrode.

Lateral overflow drains 610 and channel stops 608 formed by the methods shown in **FIGS. 7-15** can have smaller dimensions than prior art structures. This is because the sizes of opening 902 in **FIG. 9** and opening 1502 in **FIG. 15** are smaller than the achievable minimum sizes for openings 802 (**FIG. 8**) and 1302 (**FIG.13**). When formed using conventional lithography techniques, the smallest dimensions for openings 802 and 1302 are defined and constrained by the minimum dimensions that can be obtained with conventional lithography. But, since openings 902 and 1502 are formed within openings 802 and 1302, respectively, openings 902 and 1502 have smaller dimensions than openings 802 and 1302. Thus, the present invention provides accurate and repeatable methods for fabricating lateral overflow drains and channel stops with minimal feature sizes.

The invention has been described with reference to particular embodiments in accordance with the invention. However, it will be appreciated that variations and modifications can be effected by a person of ordinary skill in the art without departing from the scope of the invention. By way of example only, the order in which the fabrication steps shown in **FIG. 8** and in **FIGS. 9-10** can be reversed. Thus, oxide layer 708 and nitride layer 706 that are exposed in opening 802 are removed after the formation of lateral overflow drain 610 and channel stop 608. Additionally, the conductivity types of layer 702 and channel stop 608 can be n-type while the conductivity type of lateral overflow drain is p-type.

### PARTS LIST

- 100: insulating layer
- 102: substrate, layer, or well
- 104: nitride layer
- 200: mask layer
- 202: portion of insulating layer
- 204: channel stop
- 300: mask layer
- 302: portion of insulating layer
- 304: lateral overflow drain
- 306: overlap area
- 308: portion of insulating layer
- 400: image capture device
- 402: light
- 404: imaging stage
- 406: image sensor
- 408: processor
- 410: memory
- 412: display
- 414: other input/output (I/O) elements
- 500: pixel
- 502: imaging area
- 504: horizontal shift register
- 506: output amplifier
- 600: shift element
- 602: shift element
- 604: barrier region
- 606: barrier region
- 608: channel stop
- 610: lateral overflow drain
- 612: gate electrode
- 614: gate electrode
- 616: arrow representing direction of charge transfer
- 700: insulating layer
- 702: layer
- 704: oxide layer
- 706: nitride layer
- 708: oxide layer
- 800: hard mask layer
- 802: opening
- 900: second mask layer
- 902: opening
- 1200: field oxide
- 1300: mask layer
- 1302: opening
- 1500: mask layer
- 1502: opening

## Claims

1. A method of fabricating one or more lateral overflow drains in an image sensor, the method comprising:
forming a hard mask layer (800) over an insulating layer (700) wherein the insulating layer is disposed on a layer having a first conductivity type;
patterning the hard mask layer to create one or more first openings (802) where channel stops (608) will be formed;
forming a second mask layer (900) over the hard mask layer and the one or more first openings;
patterning the second mask layer to create one or more second openings (902) where the one or more lateral overflow drains (610) will be formed, wherein each second opening is disposed in a portion of a respective first opening and the second mask layer fills the remaining portion of each first opening;
implanting one or more dopants of a second conductivity type opposite the first conductivity type through the one or more second openings (902) and into the layer having the first conductivity type to form the one or more lateral overflow drains (610) in the layer with an edge of each lateral overflow drain self-aligned to an edge of the hard mask layer (800);
removing the second mask layer (800); and
implanting one or more dopants of the first conductivity type through the one or more first openings and into each lateral overflow drain (610) and to adjoining layer having the first conductivity type to form the one or more channel stops (608), wherein the edge of each lateral overflow drain is substantially aligned with an edge of a respective channel stop.

2. The method of claim 1, further comprising removing the hard mask layer (800).

3. The method of claim 2, further comprising forming a field oxide region (1200) over each channel stop and associated lateral overflow drain.

4. The method of claim 1, further comprising removing at least a portion of the insulating layer (700) exposed in the one or more first openings prior to forming a second mask layer over the hard mask layer and the one or more first openings.

5. An image sensor comprising,
a lateral overflow drain (610) formed within a channel stop (608) disposed in a layer, wherein an edge of the lateral overflow drain is aligned with an edge of the channel stop; and
a field oxide region (1200) disposed on the channel stop and lateral overflow drain.

## Patentansprüche

1. Verfahren zur Herstellung eines oder mehrerer seitlicher Überlauf-Drains in einem Bildsensor, wobei das Verfahren umfasst:
Ausbilden einer harten Maskenschicht (800) über einer Isolierschicht (700), worin die Isolierschicht auf einer Schicht mit einem ersten Leitfähigkeitstyp angeordnet ist;
Strukturieren der harten Maskenschicht, um eine oder mehrere erste Öffnungen (802) zu erzeugen, wo Kanalstopper (608) ausgebildet werden;
Ausbilden einer zweiten Maskenschicht (900) über der harten Maskenschicht und der einen oder den mehreren ersten Öffnungen;
Strukturieren der zweiten Maskenschicht, um eine oder mehrere zweite Öffnungen (902) zu erzeugen, wo der eine oder die mehreren seitlichen Überlauf-Drains (610) ausgebildet werden, worin jede zweite Öffnung in einem Abschnitt einer jeweiligen ersten Öffnung angeordnet ist und die zweite Maskenschicht den verbleibenden Abschnitt jeder ersten Öffnung füllt;
Implantieren eines oder mehrerer Dotanden eines zweiten Leitfähigkeitstyps, der dem ersten Leitfähigkeitstyp entgegengesetzt ist, durch die eine oder mehreren zweiten Öffnungen (902) und in die Schicht mit dem ersten Leitfähigkeitstyp hinein, um den einen oder die mehreren seitlichen Überlauf-Drains (610) in der Schicht auszubilden, wobei eine Kante jedes seitlichen Überlauf-Drains auf eine Kante der harten Maskenschicht (800) selbstausgerichtet ist;
Entfernen der zweiten Maskenschicht (900); und
Implantieren eines oder mehrerer Dotanden des ersten Leitfähigkeitstyps durch die eine oder mehreren ersten Öffnungen und in jeden seitlichen Überlauf-Drain (610) und die angrenzende Schicht mit dem ersten Leitfähigkeitstyp hinein, um den einen oder die mehreren Kanalstopper (608) auszubilden, worin die Kante jedes seitlichen Überlauf-Drains im wesentlichen auf eine Kante eines jeweiligen Kanalstoppers ausgerichtet ist.

2. Verfahren nach Anspruch 1, ferner umfassend: Entfernen der harten Maskenschicht (800).

3. Verfahren nach Anspruch 2, ferner umfassend: Ausbilden eines Feldoxidbereichs (1200) über jedem Kanalstopper und zugeordneten seitlichen Überlauf-Drain.

4. Verfahren nach Anspruch 1, ferner umfassend: Entfernen zumindest eines Abschnitts der Isolierschicht (700), der in der einen oder den mehreren ersten Öffnungen freigelegt ist, bevor eine zweite Maskenschicht über der harten Maskenschicht und der einen oder den mehreren ersten Öffnungen ausgebildet wird.

5. Bildsensor, umfassend:
einen seitlichen Überlauf-Drain (610), der innerhalb eines in einer Schicht angeordneten Kanalstoppers (608) ausgebildet ist, worin eine Kante des seitlichen Überlauf-Drains auf eine Kante des Kanalstoppers ausgerichtet ist; und
einem Feldoxidbereich (1200), der auf dem Kanalstopper und dem seitlichen Überlauf-Drain angeordnet ist.

## Revendications

1. Procédé de fabrication d'un ou plusieurs drains de trop-pleins latéraux dans un capteur d'image, le procédé comprenant :
la formation d'une couche de masque dur (800) sur une couche isolante (700), dans laquelle la couche isolante est disposée sur une couche présentant un premier type de conductivité ;
le modelage de la couche de masque dur en vue de créer une ou plusieurs premières ouvertures (802) où des arrêts de canal (608) seront formés ;
la formation d'une seconde couche de masque (900) sur la couche de masque dur et ladite une ou lesdites plusieurs premières ouvertures ;
le modelage de la seconde couche de masque en vue de créer une ou plusieurs secondes ouvertures (902), où ledit un ou lesdits plusieurs drains de trop-pleins latéraux (610) seront formés, dans lequel chaque seconde ouverture est disposée dans une partie d'une première ouverture respective et la seconde couche de masque remplit la partie restante de chaque première ouverture ;
l'implantation d'un ou plusieurs dopants d'un second type de conductivité opposé au premier type de conductivité à travers ladite une ou lesdites plusieurs secondes ouvertures (902), et dans la couche présentant le premier type de conductivité, en vue de former ledit un ou lesdits plusieurs drains de trop-pleins latéraux (610) dans la couche, avec un bord de chaque drain de trop-plein latéral auto-aligné sur un bord de la couche de masque dur (800) ;
la suppression de la seconde couche de masque (900) ; et
l'implantation d'un ou plusieurs dopants du premier type de conductivité à travers ladite une ou lesdites plusieurs premières ouvertures et dans chaque drain de trop-plein latéral (610) et chaque couche contigüe présentant le premier type de conductivité, en vue de former ledit un ou lesdits plusieurs arrêts de canal (608), dans lequel le bord de chaque drain de trop-plein latéral est sensiblement aligné avec un bord d'un arrêt de canal respectif.

2. Procédé selon la revendication 1, comprenant en outre la suppression de la couche de masque dur (800).

3. Procédé selon la revendication 2, comprenant en outre la formation d'une région d'oxyde de champ (1200) sur chaque arrêt de canal et drain de trop-plein latéral associé.

4. Procédé selon la revendication 1, comprenant en outre la suppression d'au moins une partie de la couche isolante (700) exposée dans ladite une ou lesdites plusieurs premières ouvertures avant la formation d'une seconde couche de masque sur la couche de masque dur et ladite une ou lesdites plusieurs premières ouvertures.

5. Capteur d'image comprenant :
un drain de trop-plein latéral (610) formé au sein d'un arrêt de canal (608) disposé dans une couche, dans lequel un bord du drain de trop-plein latéral est aligné avec un bord de l'arrêt de canal ; et
une région d'oxyde de champ (1200) disposée sur l'arrêt de canal et le drain de trop-plein latéral.
